(19) Europäisches Patentamt
European Patent Office
Office européen des brevets

(11) **EP 3 211 499 B1**

(12) **EUROPÄISCHE PATENTSCHRIFT**

(45) Veröffentlichungstag und Bekanntmachung des Hinweises auf die Patenterteilung:
**26.09.2018 Patentblatt 2018/39**

(51) Int Cl.:
**G05B 19/4093** *(2006.01)* **B21D 5/00** *(2006.01)*
**B21D 5/04** *(2006.01)*

(21) Anmeldenummer: **17156876.9**

(22) Anmeldetag: **20.02.2017**

(54) **VERFAHREN, COMPUTERPROGRAMMPRODUKT UND SCHWENKBIEGEMASCHINE ZUM BIEGEN VON BLECHEN**

METHOD, COMPUTER PROGRAM PRODUCT AND BENDING MACHINE FOR BENDING METAL SHEETS

PROCEDE, PRODUIT PROGRAMME INFORMATIQUE ET MACHINE A PLIER POUR LE PLIAGE DE TOLES

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **22.02.2016 AT 501172016**

(43) Veröffentlichungstag der Anmeldung:
**30.08.2017 Patentblatt 2017/35**

(73) Patentinhaber:
• **Scharsach, Henning**
**1020 Wien (AT)**
• **Tschanter, Markus**
**3004 Reichersberg (AT)**

(72) Erfinder:
• **Scharsach, Henning**
**1020 Wien (AT)**
• **Tschanter, Markus**
**3004 Reichersberg (AT)**

(74) Vertreter: **Weiser & Voith**
**Patentanwälte Partnerschaft**
**Kopfgasse 7**
**1130 Wien (AT)**

(56) Entgegenhaltungen:
WO-A1-2015/126266 DE-T2- 69 535 687
DE-T2- 69 838 336 JP-A- H06 142 768

# Beschreibung

Die vorliegende Erfindung betrifft ein Verfahren zum Herstellen eines Werkstücks mit zumindest zwei Biegungen durch Biegen eines Blechrohlings, wobei zumindest eine der Biegungen in zwei Varianten herstellbar ist. Die Erfindung betrifft ferner ein Computerprogrammprodukt und eine Schwenkbiegemaschine zur Implementierung des genannten Verfahrens.

Zum Biegen von Blechen auf Gesenk- oder Schwenkbiegemaschinen wird zunächst eine Reihenfolge der am Blechrohling vorzunehmenden Biegungen ermittelt, um das Werkstück anschließend möglichst effizient, zeit- und ressourcenschonend herzustellen. Jede vorzunehmende Biegung kann dabei meist in verschiedenen Varianten hergestellt werden, z.B. durch Biegen nach oben oder unten, unter Wenden oder Drehen des Rohlings, durch manuelles oder maschinelles Biegen, usw. Unterschiedliche Varianten haben in der Regel unterschiedlich lange Herstellungszeiten während der Produktion zur Folge, wodurch eine bestimmte Reihenfolge von Biegungen in jeweils einer bestimmten Biegungsvariante, eine sog. "Biegesequenz", jeweils eine bestimmte Herstellungszeit erfordert.

Aus der Kombination aller möglichen Reihenfolgen der Biegungen und deren verschiedenen Biegungsvarianten ergibt sich jedoch eine enorm große Anzahl von möglichen Biegesequenzen, nämlich (Anzahl der Biegungen)! * (Anzahl der Varianten) ^(Anzahl der Biegungen). So ergeben sich beispielsweise für zehn Biegungen, die jeweils in vier Varianten hergestellt werden können, bereits $10! * 4^{10} \approx 4$ Billionen mögliche Biegesequenzen.

Das Auffinden der optimalen Biegesequenz ("Biegestrategie") zur Herstellung eines Werkstücks mit einer vorgegebenen Abfolge von Biegungen mit bestimmten Biegewinkeln in bestimmten gegenseitigen Abständen ("Profilgeometrie"), u.zw. optimal in Bezug auf eine minimale Herstellungszeit und minimale Anzahl von Manipulationsschritten am Rohling, ist daher angesichts der enormen Zahl möglicher Biegesequenzen ein nichttriviales Problem. Selbst das Auffinden einer bloß suboptimalen Biegesequenz erfordert in der Praxis jahrelange Erfahrung, um in vertretbarer Zeit zu einer brauchbaren Biegesequenz zu gelangen.

Es wurden daher bereits computerunterstützte Verfahren entwickelt, welche eine große Zahl möglicher Biegesequenzen "durchprobieren", doch gelangen diese Verfahren entweder zu deutlich schlechteren Lösungen als erfahrene Spezialisten oder benötigen unvertretbar hohe Rechenzeit oder Rechenleistung. Da für jede Biegungsvariante in einer Biegesequenz stets auch berechnet werden muss, ob Kollisionen beim Biegen des Blechrohlings durch bereits hergestellte Biegungen auftreten würden, verlängert sich die Rechenzeit mit jeder weiteren, einer Biegesequenz hinzugefügten Biegungsvariante entsprechend.

Die Schrift DE 695 35 687 T2 zeigt ein derartiges computergestütztes Verfahren, das sowohl eine Tiefensuche als auch eine Breitensuche zur Ermittlung von Knoten in der Biegesequenz vorschlägt, jedoch keine optimierte Lösung bereitstellt.

Die Erfindung setzt sich zum Ziel, die Nachteile des Standes der Technik zu überwinden und ein Verfahren zu schaffen, das in einer kurzen Rechenzeit qualitativ hochwertige Ergebnisse liefert, d.h. Biegesequenzen mit kurzen Herstellungszeiten, um das Werkstück damit rasch und effizient zu fertigen.

Diese Aufgabe wird gemäß einem ersten Aspekt der Erfindung mit einem Verfahren der einleitend genannten Art gelöst, das die folgenden Schritte umfasst:

a) Bereitstellen eines Satzes von Biegesequenzen umfassend jeweils eine Biegungsvariante, wobei sich die Biegungsvarianten aus der Gesamtheit der Biegungen in allen deren Varianten ergeben, und Speichern des Satzes als Auswahlsatz;

b) Erweitern des Satzes um neue Biegesequenzen, die jeweils aus einer Biegesequenz des Auswahlsatzes ergänzt um zumindest eine weitere jeweils mögliche Biegungsvariante bestehen, über eine vorgegebene Zeitspanne oder bis eine vorgegebene Anzahl neuer Biegesequenzen erreicht ist;

c) Berechnen eines Scores für jede Biegesequenz des Satzes jeweils in Abhängigkeit von Bewertungen der Biegungsvarianten in dieser Biegesequenz und der für die Berechnung dieser Biegesequenz verbrauchten Rechenzeit, wobei die verbrauchte Rechenzeit ein negatives Qualitätsmaß darstellt;

d) Auswählen der Biegesequenzen mit den N besten Scores unter allen Biegesequenzen des Satzes und Speichern der ausgewählten Biegesequenzen als Auswahlsatz durch Überschreiben des alten Auswahlsatzes;

e) wenn eine vorgegebene Rechenzeit noch nicht erreicht ist, Wiederholen der Schritte b) bis d), andernfalls Biegen des Blechrohlings mit einer der Biegesequenzen des Auswahlsatzes, in der alle Biegungen vorhanden sind.

Gemäß dem Verfahren wird in Schritt b) ein Algorithmus angewandt, mittels welchem neue Biegesequenzen ermittelt werden. Erfindungsgemäß wird nach einer vorgegebenen Zeitspanne, z.B. periodisch, ein "Snapshot" der bereits ermittelten, möglicherweise noch nicht alle Biegungen beinhaltenden, d.h. "unfertigen", Biegesequenzen erstellt, um abzuschätzen, welche von diesen Biegesequenzen beim weiteren Vervollständigen zu niedrigen Herstellungszeiten führen könnten; diese werden ausgewählt und als Ausgangsbasis für die weiteren zu ermittelnden Biegesequenzen eingesetzt.

Das Verfahren bewirkt somit ein periodisches signifikantes "Ausdünnen" der Vielzahl möglicher Biegesequenzen, um die zur Verfügung stehende Rechenleistung und Rechenzeit zum Vervollständigen der jeweils potentiell "besten" Biegesequenzen, das sind z.B. jene mit den voraussichtlich niedrigsten Herstellungszeiten und -kosten, einzusetzen. Erfindungsgemäß werden dazu Bewertungen der Biegungsvarianten in diesen Biegesequenzen und die für die Berechnung dieser Biegesequenzen jeweils aufgewendete Rechenzeit herangezogen. Die Erfindung beruht dabei auf der Erkenntnis, dass die für eine (unfertige) Biegesequenz verbrauchte Rechenzeit gleichsam ein "negatives Qualitätsmaß" ist, d.h. eine "schlechte" Biegesequenz mit z.B. besonders hohem Kollisionspotenzial anzeigt.

Bevorzugt wird eine Biegung durch einen Biegewinkel, einen Biegeabstand von einer Kante des Blechrohlings und optional einen Winkel zu einer Kante des Blechrohlings definiert. Dies ermöglicht eine besonders einfache Kollisionsermittlung, wodurch die diesbezüglich verwendete Rechenzeit minimiert wird.

Weiters bevorzugt wird eine Variante einer Biegung durch zumindest einen der Biegeparameter Biegerichtung, Blechrohling-Wenderichtung, Blechrohling-Drehrichtung und Werkzeugwechsel definiert. Die Parameter Biege- und Wenderichtung sind besonders bei einseitig beschichteten Blechrohlingen von Vorteil, da durch entsprechende Wahl die Beschichtung des Blechs geschont werden kann. Die Drehrichtung gibt an, ob der Blechrohling für das Biegen umgespannt werden muss. Der Parameter Werkzeugwechsel kann angeben, ob ein anderes Biegewerkzeug, eine andere Biegemaschine oder ein manuelles Biegen eingesetzt werden soll, um z.B. höhere oder genauere Biegewinkel zu erreichen.

In einer weiteren vorteilhaften Ausführungsform der Erfindung umfasst im Schritt b) das Erzeugen einer Biegesequenz das Anwenden eines Satzes von Regeln auf die jeweilige Biegesequenz des Auswahlsatzes und auf alle weiteren möglichen Biegungsvarianten, um zu ermitteln, welche dieser Biegesequenzen dem Satz hinzugefügt wird/werden. Diese Lösung schafft eine Möglichkeit, die Biegesequenzen z.B. unter Verwendung von Kollisionsregeln strukturell weiterzuentwickeln. Alternativ kann auch ein Algorithmus eingesetzt werden, mittels welchem Biegesequenzen durch zufällige Auswahl erstellt werden, um Biegesequenzen schneller zu ermitteln. Beide Algorithmen können auch parallel oder sequentiell eingesetzt werden.

In der vorgenannten Ausführungsform liefert bevorzugt jede Regel eine Bewertung hinsichtlich eines im herzustellenden Werkstück identifizierten Biegemusters, hinsichtlich der in der Biegesequenz enthaltenen Varianten und/oder hinsichtlich auftretender Biegekollisionen. Beispielsweise kann ein identifiziertes Biegemuster ein Falz an einem Ende des Werkstücks sein, der erfahrungsgemäß am besten am Anfang einer Biegesequenz gefertigt wird, wodurch die Biegungen eines solchen Musters eine gute Bewertung erhalten. Die Bewertung der Varianten bezieht sich darauf, ob das Werkstück mit dieser Biegesequenz schnell gefertigt werden kann, z.B. mit wenigen Rohling-Umspannschritten oder manuellen Fertigungsschritten.

Bevorzugt werden die im Schritt c) genannten Bewertungen hinsichtlich eines im herzustellenden Werkstück identifizierten Biegemusters oder hinsichtlich der in der Biegesequenz enthaltenen Varianten ermittelt. Dadurch können in der genannten "Snapshot"-Auswahl sowohl Biegemuster als auch geschätzte Herstellungsgeschwindigkeiten berücksichtigt werden.

Weiters bevorzugt beträgt die genannte vorgegebene Zeitspanne 0,1 bis 3 Sekunden, insbesondere bevorzugt 0,2 bis 2 Sekunden, wodurch die "Snapshot"-Auswahl der "weiterzubauenden" erfolgversprechensten Biegesequenzen - z.B. bei einer zur Verfügung stehenden Rechenzeit von 6 bis 20 Sekunden - 1 bis 200 mal durchgeführt werden kann. Dadurch ergibt sich ein gutes Verhältnis zwischen Neuberechnungen von Biegesequenzen mittels des Algorithmus von Schritt b) und Neuauswählen von Ausgangsbiegesequenzen. Die genannte vorgegebene Zeitspanne kann jedoch auch von der Anzahl von Biegungen und Varianten abhängig sein.

In einer weiteren bevorzugten Ausgestaltung der Erfindung beträgt die genannte vorgegebene (Gesamt-)Rechenzeit 6 bis 20 Sekunden, besonders bevorzugt 10 bis 15 Sekunden. Dadurch können Biegesequenzen mit kurzen Herstellungszeiten ermittelt werden, ohne dass sich für den Anwender des Verfahrens eine übermäßige Wartezeit zwischen Eingabe der Biegedaten und dem Starten des Biegens des Blechrohlings ergibt.

Gemäß einem zweiten Aspekt der Erfindung wird ein Computerprogrammprodukt zum Steuern einer programmierbaren Schwenkbiegemaschine geschaffen, welches auf einem maschinenlesbaren Datenträger verkörpert und dafür ausgebildet ist, wenn die Schwenkbiegemaschine damit programmiert ist, das genannte Verfahren auszuführen.

Gemäß einem dritten Aspekt der Erfindung wird eine Schwenkbiegemaschine mit einer Programmsteuerung geschaffen, die dafür programmiert ist, das genannte Verfahren auszuführen.

Bezüglich der Vorteile des Computerprogrammprodukts und der Schwenkbiegemaschine gemäß dem zweiten bzw. dritten Aspekt der Erfindung wird auf die Vorteile des Verfahrens gemäß dem ersten Aspekt der Erfindung verwiesen.

Die Erfindung wird nachstehend anhand von in den beigeschlossenen Zeichnungen dargestellten Ausführungsbeispielen näher erläutert. In den Zeichnungen zeigen:

die Fig. 1a und 1b eine Schwenkbiegemaschine zur Durchführung des erfindungsgemäßen Verfahren ausschnittsweise in zwei verschiedenen Betriebszuständen;
die Fig. 2a - 2c Beispiele von mit dem Verfahren der Erfindung herzustellenden Werkstücken;
Fig. 3 eine beispielhafte Definition einer Profilgeometrie für ein Werkstück mit mehreren Biegungen;
Fig. 4 eine beispielhafte Definition der Biegevarianten einer Biegung der Profilgeometrie von Fig. 3;
Fig. 5 ein Flussdiagramm des erfindungsgemäßen Verfahrens;

Fig. 6 beispielhafte Biegesequenzen in dem Verfahren von Fig. 5;

Fig. 7 das Erstellen der Biegesequenzen von Fig. 6 gemäß einem Satz von Regeln; und

Fig. 8 erstellte Biegesequenzen zu verschiedenen Zeitpunkten im Verlauf des Verfahrens von Fig. 5 in aufeinanderfolgenden Baumdarstellungen.

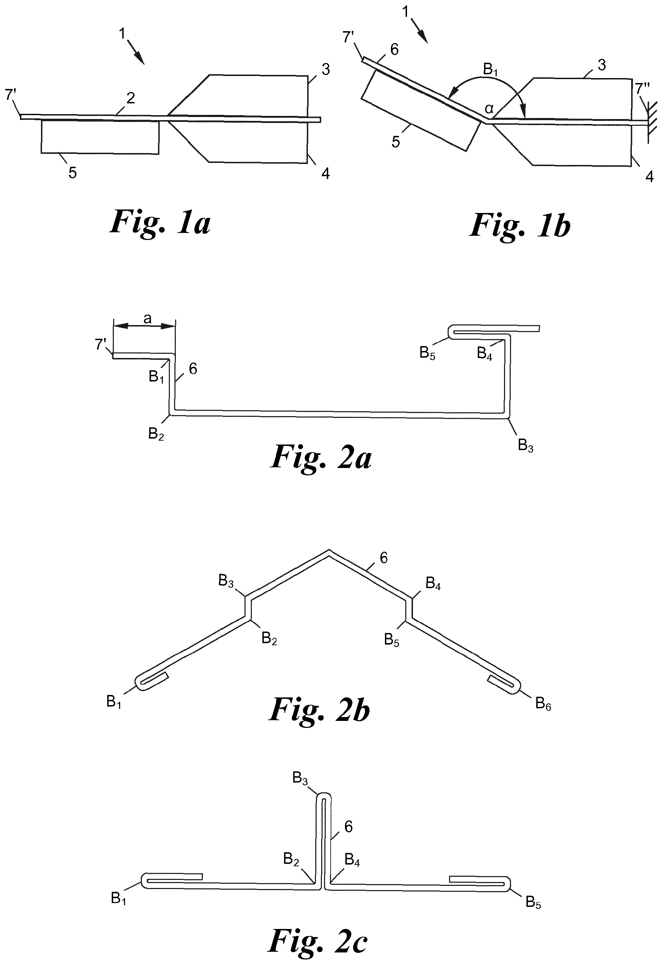

Fig. 1a zeigt ausschnittsweise eine Schwenkbiegemaschine 1, in der ein Blechrohling 2 zwischen einer Oberwange 3 und einer Unterwange 4 eingespannt ist. Aus der Abfolge der Fig. 1a und 1b ist ersichtlich, dass der Blechrohling 2 durch Bewegen einer Biegewange 5 zu einem Halbzeug bzw. Werkstück 6 mit einer Biegung $B_1$ umgeformt wird. Das Biegen kann wie gezeigt durch Schwenkbiegen erfolgen oder alternativ auch durch andere im Stand der Technik bekannte Umformverfahren wie Gesenkbiegen.

Die Fig. 2a, 2b und 2c zeigen einige Beispiele von Werkstücken 6, die mit einer Vielzahl verschiedener Biegungen $B_1$, $B_2$, ..., allgemein $B_i$, hergestellt sind und dadurch verschiedenste Formen aufweisen. Die Biegungen $B_i$ der Werkstücke 6 werden dabei jeweils in einer bestimmten Reihenfolge gebogen, was dem fertigen Werkstück jedoch nicht angesehen werden kann. Die Gesamtheit aller Biegungen $B_i$ des Werkstücks 6 wird im Folgenden mit {B} bezeichnet.

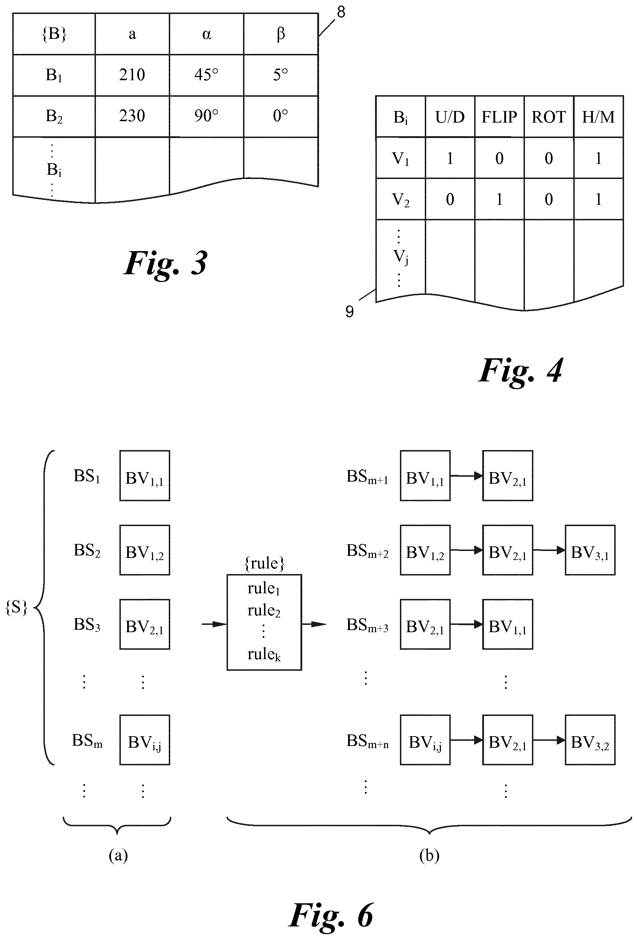

Fig. 3 zeigt ein Beispiel einer Definition 8 der Biegungen {B} ("Profilgeometrie") des Werkstücks 6. Jede Biegung $B_i$ ist z.B. durch einen Biegeabstand a von einer Kante 7' des Blechrohlings 2 oder einem Anschlag 7" der Schwenkbiegemaschine 1 (siehe Fig. 1b, 2a), einen Biegewinkel $\alpha$ und (optional) einen Winkel $\beta$ zu der Kante 7' oder dem Anschlag 7" definiert.

Gemäß Fig. 4 kann bei der Herstellung des Werkstücks 6 jede Biegung $B_i$ auf unterschiedliche Art, d.h. in einer Vielzahl von Varianten $V_1$, $V_2$, ..., allgemein $V_j$, erzeugt werden. Jede Variante $V_j$ der Biegung $B_i$ kann dabei durch verschiedenste Biegeparameter wie Biegerichtung "U/D" (1 = up, 0 = down), Blechrohling-Wenderichtung "FLIP" (1 = Wenden, 0 = Belassen), "ROT" (1 = Drehen, 0 = Belassen), Werkzeugwechsel "H/M" (1 = händisch, 0 = maschinell; oder Werkzeugnummer) usw. definiert werden. Die Gesamtheit der Varianten $V_j$ einer Biegung $B_i$ wird im Folgenden mit $\{V\}_{Bi}$ bezeichnet, eine Biegung $B_i$ in der Variante $V_j$ als "Biegungsvariante" $BV_{i,j}$, und die Gesamtheit aller solcher Biegungsvarianten mit {BV}.

Eine bestimmte Reihenfolge von Biegungen $B_i$ in einer jeweiligen Biegungsvariante $BV_{i,j}$, mit der das Werkstück 6 hergestellt werden kann, wird als "fertige" bzw. "vollständige" Biegesequenz bezeichnet; ein Teil davon als "unfertige" bzw. "unvollständige" Biegesequenz BS.

Durch die Vielzahl von Biegungen $B_i$ und deren Varianten $V_j$ ergibt sich eine enorme Anzahl an potentiellen Biegesequenzen $BS_1$, $BS_2$, ..., allgemein $BS_m$. Einige dieser potentiellen Biegesequenzen $BS_m$ sind jedoch aufgrund von Kollisionen nicht durchführbar oder würden aufgrund häufiger Werkzeugwechsel, Umspannschritte des Blechrohlings 2, manuelle Biegeschritte usw. eine sehr lange Herstellungszeit und/oder sehr hohe Herstellungskosten benötigen.

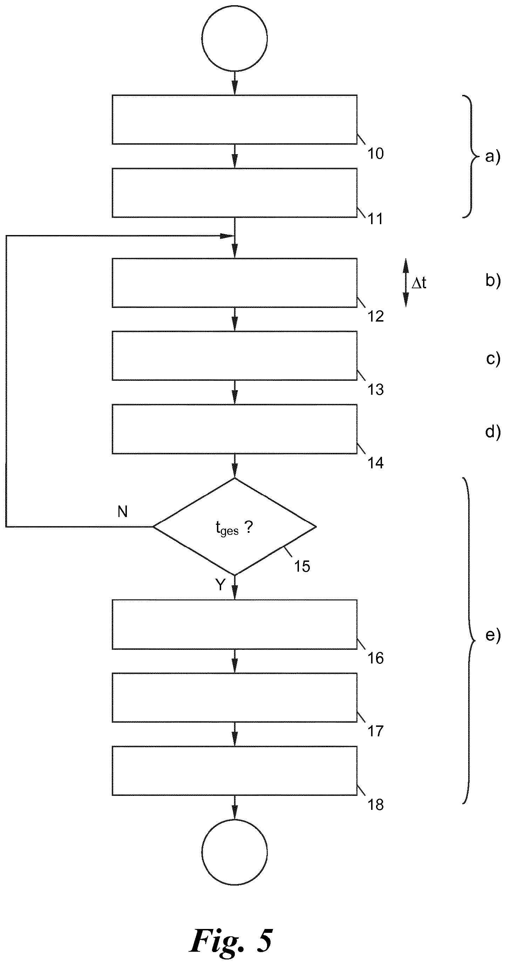

Das Ermitteln der am besten geeigneten, d.h. schnellsten oder ressourcenschonendsten, vollständigen Biegesequenz(en) wird nun anhand der Fig. 6 bis 8 beschrieben, wobei jeweils auf das Flussdiagramm von Fig. 5 Bezug genommen wird.

Fig. 5 zeigt oben und Fig. 6 links den anfänglichen Schritt a) des Bereitstellens eines ersten (Start-)Satzes {S} von (zunächst noch unvollständigen) Biegesequenzen $BS_m$, der sich aus allen grundsätzlich möglichen Varianten j aller als erste Biegung der Sequenz zu verwendenden Biegungen $B_i$, d.h. allen Biegungsvarianten {BV}, zusammensetzt (10). Dieser Satz {S} wird als erster Auswahlsatz {AS} gespeichert (11).

Im nächsten Schritt b) wird der Auswahlsatz {AS} um eine Vielzahl von in diesem Schritt b) zu ermittelnden Biegesequenzen $BS_{m+n}$ erweitert (12), wobei der Index n die n-te im Schritt b) erzeugte neue Biegesequenz bezeichnet. Jede neue Biegesequenz $BS_{m+n}$ setzt sich dabei aus einer der früher ermittelten (unvollständigen) Biegesequenzen $BS_m$, ergänzt bzw. weiter vervollständigt um eine (oder mehrere) nächste noch vorzunehmende Biegung(en) $B_i$ in einer jeweiligen Variante $V_j$, d.h. um eine (oder mehrere) weitere Biegungsvariante(n) $BV_{i,J}$, zusammen.

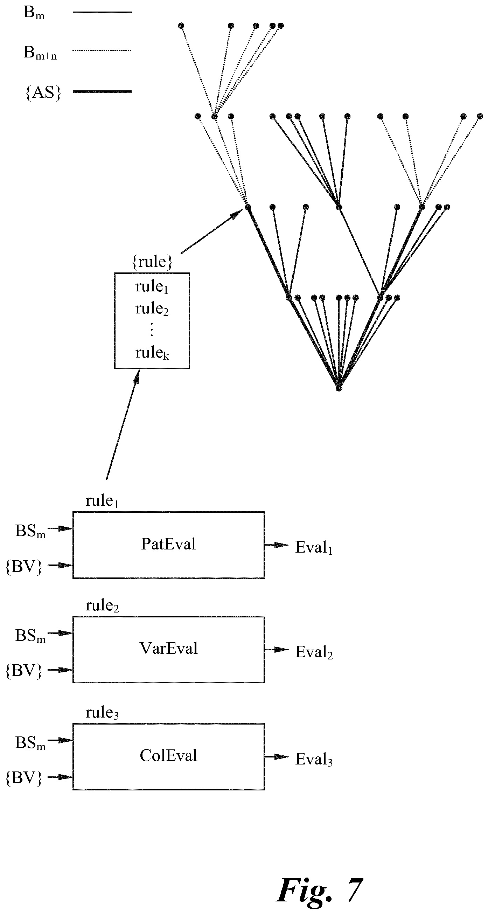

Fig. 7 zeigt einen möglichen Algorithmus zum Ermitteln einer solchen neuen Biegesequenz $BS_{m+n}$. Um eine im Satz {S} vorhandene (unfertige) Biegesequenz $BS_m$ weiterzuentwickeln, wird zunächst ermittelt, welche Biegungen $B_i$ noch nicht in der Biegesequenz $BS_m$ vorhanden sind. Daraufhin werden alle Biegungsvarianten $BV_{i,j}$ ermittelt, die für diese Biegungen $B_i$ noch möglich sind. Ein Satz {rule} von Regeln $rule_1$, $rule_2$, ..., allgemein $rule_k$, wird auf jede Kombination angewandt, die sich aus der Biegesequenz $BS_m$ und allen zu deren weiterer Vervollständigung ("Verlängerung") möglichen Biegungsvarianten $BV_{i,J}$ ergibt, um neue Biegesequenzen $BS_{m+n} = BS_m + BV_{i,j}$ zu erzeugen.

Die Regeln $rule_k$ können in mehrere Klassen unterteilt sein, wovon drei hier beispielhaft dargestellt sind. So könnte beispielsweise die Regel $rule_1$ eine Bewertung $Eval_1$ hinsichtlich eines im herzustellenden Werkstück 6 identifizierten Biegemusters liefern. So kann z.B. im Muster von Fig. 2b erkannt werden, dass die zwei Falz-Biegungen $B_1$, $B_7$ besonders einfach am Anfang des Verfahrens erzeugt werden können, weshalb sie an entsprechender Position in einer Biegesequenz dann eine gute Bewertung $Eval_1$ erhalten würden. Solche zu erkennenden Muster basieren auf Experten-Regeln; z.B. auch konkave Verläufe wie $B_2$-$B_3$-$B_4$-$B_5$-$B_6$ könnten erkannt und eine Bewertung $Eval_1$ erfahren.

Andere Regeln $rule_2$ liefern z.B. eine Bewertung $Eval_2$ hinsichtlich der in der (unfertigen) Biegesequenz

$BS_m$ bereits enthaltenen Varianten $BV_{i,j}$, für welche beispielsweise ein häufiger Werkzeugwechsel oder ein häufiges Drehen oder Wenden des Blechrohlings als schlecht bewertet würden. Wieder andere Regeln ru-le$_3$ liefern z.B. eine Bewertung Eval$_3$ hinsichtlich einer zu erwartenden Biegekollision, wodurch nicht fertigbare Biegesequenzen $BS_{m+n}$ ausgeschieden werden können.

Es versteht sich, dass nicht alle Regeln rule$_k$ angewandt werden müssen, sondern beispielsweise das Anwenden der Regeln des Satzes {rule} beim Eintreten von bestimmten Kriterien auch frühzeitig abgebrochen werden kann, wodurch sich unterschiedliche Rechenzeiten $t_r$ für die Erzeugung unterschiedlicher Biegesequenzen $BS_{m+n}$ ergeben können.

Jene neue Biegesequenzen $BS_{m+n}$ mit den besten Bewertungen - oder auch alle fertigbaren - werden in Schritt b) dem Satz {S} hinzugefügt, wodurch dieser erweitert wird (12). Anstatt nur einer Biegungsvariante $BV_{i,j}$ können auch gleich mehrere Biegungsvarianten nacheinander zu einer vorhandenen Biegesequenz $BS_m$ hinzugefügt werden, beispielsweise jeweils mit dem oben beschriebenen Algorithmus. Um dies zu ermöglichen, können neu erzeugte Biegesequenzen $B_{m+n}$ die ihnen zugrundeliegenden Biegesequenzen $BS_m$ im Auswahlsatz {AS} ersetzen oder diesem hinzugefügt werden.

Beim Hinzufügen von Biegevarianten $BV_{i,j}$ zu den Biegesequenzen $BS_m$ des Satzes {S} in Schritt b) werden somit sukzessive längere Biegesequenzen $BS_{m+n}$ erzeugt, bis in einer Biegesequenz $BS_{m+n}$ alle Biegungen {B} vorhanden sind. Eine beispielhaft Biegesequenz $BS_m$ kann z.B. gegeben sein durch die Reihenfolge $BS_m = BV_{3,2} \rightarrow BV_{1,1} \rightarrow BV_{4,3} \rightarrow ....$

Der Schritt b) des Erweiterns (12) des Satzes {S} wird solange durchgeführt, bis entweder eine vorgegebene Zeitspanne $\Delta t$ verstrichen ist oder eine vorgegebene Anzahl M neuer Biegesequenzen $BS_{m+n}$ erzeugt worden ist. Die Zeitspanne $\Delta t$ kann z.B. im Bereich von 0,1 bis 3 Sekunden, insbesondere 0,2 bis 2 Sekunden, liegen. Die vorgegebene Anzahl M von neuen Biegesequenzen $BS_{m+n}$ kann z.B. auch ein bestimmter Prozentsatz aller möglichen Biegesequenzen $BS_m$ sein.

Nach dem - oder auch schon während des - Schritt (es) b) wird in einem Schritt c) ein Score $SC_m$ für jede Biegesequenz $BS_m$ des (nun erweiterten) Satzes {S} berechnet (13).

Der Score $SC_m$ setzt sich einerseits zusammen aus der für die Berechnung dieser Biegesequenz $BS_m$ bislang insgesamt aufgewendeten ("verbrauchten") Rechenzeit $t_r$, die aufgrund der unterschiedlichen Komplexität des Regelsatzes {rule} für die verschiedenen Biegesequenzen $BS_m$ und der jeweils unterschiedlich zur Verfügung stehenden Biegungsvarianten $BV_{i,j}$ für jede Biegesequenz $BS_m$ individuell verschieden ist.

Andererseits setzt sich der Score $SC_m$ aus einer oder mehreren der Bewertungen Eval$_1$, Eval$_2$, Eval$_3$, allgemein Eval$_p$, der Biegungsvarianten $BV_{i,j}$ in dieser Biegesequenz $BS_m$ zusammen. Die Bewertungen können dabei dieselben sein wie in Schritt b) und auch aus demselben Rechenprozess stammen oder alternativ gesonderte Bewertungen sein. Es ist deshalb ersichtlich, dass die Schritte b) und c) optional auch gleichzeitig durchgeführt werden könnten.

Mittels einer optionalen Funktion f, die z.B. auch eine Gewichtung ihrer Argumente enthalten kann, berechnet sich der Score $SC_m$ einer Biegesequenz $BS_m$ somit beispielsweise zu

$$SC_m = f(\{Eval_p(BS_m)\}, t_r(BS_m)).$$

Die Rechenzeit $t_r$ einer Biegeseqenz $BS_m$ setzt sich dabei zusammen aus den einzelnen Rechenzeiten $t_{r,i,j}$ der in der Biegesequenz $BS_m$ enthaltenen Biegungsvarianten $BV_{i,j}$ gemäß

$$t_r = \sum t_{r,i,j}.$$

In einem anschließenden Schritt d) werden die Biegesequenzen $BS_m$ aus dem Satz {S} mit den N besten Scores $SC_m$ (N = 1, 2, ...) ausgewählt und als neuer Auswahlsatz {AS} gespeichert (14), d.h. der alte Auswahlsatz {AS} wird damit überschrieben. Dadurch werden "schlechte", wenig erfolgversprechende Biegesequenzen $BS_m$ aus dem Auswahlsatz {AS} ausgeschieden, und diese ausgeschiedenen Biegesequenzen $BS_m$ können folglich auch nicht mehr als Basis für neue Biegesequenzen $BS_{m+n}$ dienen, da sie nicht länger im Auswahlsatz {AS} vorhanden sind.

Nach dem Auswahl- und Speicherschritt d) wird in einem Schritt e) überprüft, ob eine vorgegebene (Gesamt-)Rechenzeit $t_{ges}$ erreicht ist oder nicht (15). Wenn nicht (Zweig "N"), wird zu Schritt b) zurückgesprungen, um die Schritte b) - d) bis zum erneuten Test 15 zu wiederholen. Wenn jedoch der Test 15 ergibt, dass die vorgegebene Rechenzeit $t_{ges}$ erreicht worden ist (Zweig "Y"), wird die Schleife b) - d) verlassen und zu Teilschritt 16 des Schritts e) übergegangen, in welchem nun jene Biegesequenzen $BS_m$ des Auswahlsatzes {AS} ermittelt werden, die alle Biegungen {B} enthalten.

Die im Teilschritt 16 ermittelten Biegesequenzen $BS_m$ können optional noch weiter hinsichtlich ihrer Fertigungsgeschwindigkeit ausgewertet werden, z.B. mittels der genannten Bewertung Eval$_2$ hinsichtlich der in der Biegesequenz $BS_m$ enthaltenen Varianten $V_j$, um unter diesen Biegesequenzen $BS_m$ weiter zu selektieren (17). Alternativ kann der Selektionsschritt 17 entfallen und eine zufällige dieser vollständigen Biegesequenzen $BS_m$ selektiert werden, oder vom Benutzer eine der am Ausgang des Schrittes 16 erhaltenen Biegesequenzen $BS_m$ in Schritt 17 manuell selektiert werden.

Im letzten Teilschritt 18 des Schrittes e) wird schließlich der Blechrohling 2 gemäß der selektierten vollständigen Biegesequenz $BS_m$ von der Biegemaschi-

ne 1 gebogen.

Es ist ersichtlich, dass die vorgegebene Zeitspanne $\Delta t$, über welche in Schritt b) der Satz {S} um neue Biegesequenzen $BS_{m+n}$ erweitert wird, jene Zeitpunkte definiert, zu denen der Satz {S} jeweils mittels der Schritte c) und d) - wie in einem "Snapshot" - neu bewertet wird, um daraus den Auswahlsatz {AS} von im nächsten Schleifendurchlauf b) - d) "weiterzubauenden" Biegesequenzen $BS_m$ zu bestimmen.

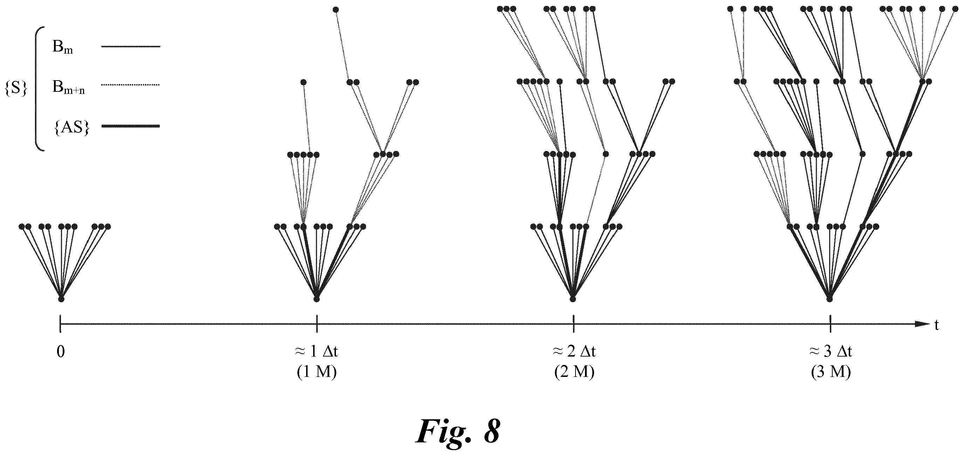

Fig. 8 zeigt dies im Detail anhand von aufeinanderfolgenden "Snapshots" des Satzes {S} ausgehend vom Start-(Auswahl)-Satz zu einem Zeitpunkt 0 und nach etwa $1\Delta t$, $2\Delta t$ und $3\Delta t$, d.h. nach einem, zwei bzw. drei Durchläufen der Schleife b) - d). Die Biegesequenzen des Satzes {S} sind dabei jeweils als Äste eines Entscheidungsbaumes dargestellt, dessen Knoten jeweils eine Biegungsvariante $BV_{i,j}$ repräsentieren.

Die jeweils in Schritt d) für das "Weiterbauen" selektierten Biegesequenzen des Satzes {S}, d.h. der Auswahlsatz {AS} für den Schritt b) des nächsten Durchlaufs, sind mit dicken ausgezogenen Linien veranschaulicht, der Satz neu hinzugefügter Biegesequenzen $B_{m+n}$ mit punktierten Linien und andere Biegesequenzen $B_m$ des Satzes {S} mit dünnen ausgezogenen Linien.

Die vorgegebene Rechenzeit $t_{ges}$, nach der die Schleife b) - d) abgebrochen und das Biegen e) durchgeführt wird, beträgt bevorzugt 6 bis 20 Sekunden, besonders bevorzugt 10 bis 15 Sekunden, und kann auch dynamisch in Abhängigkeit der Anzahl bzw. Fertigungsgeschwindigkeit der vollständigen Biegesequenzen $BS_m$ angepasst werden.

Die Erfindung ist demgemäß nicht auf die dargestellten Ausführungsformen beschränkt, sondern umfasst alle Varianten, Modifikationen und deren Kombinationen, die in den Rahmen der angeschlossenen Ansprüche fallen.

**Patentansprüche**

1. Verfahren zum Herstellen eines Werkstücks (6) mit zumindest zwei Biegungen ($B_i$) durch Biegen eines Blechrohlings (2), wobei zumindest eine der Biegungen ($B_i$) in zwei Varianten ($V_j$) herstellbar ist, umfassend die folgenden Schritte:

   a) Bereitstellen (10) eines Satzes ({S}) von Biegesequenzen ($BS_m$) umfassend jeweils eine Biegungsvariante ($BV_{i,j}$), wobei sich die Biegungsvarianten ($BV_{i,j}$) aus der Gesamtheit der Biegungen ($B_i$) in allen deren Varianten ($V_j$) ergeben, und Speichern (11) des Satzes ({S}) als Auswahlsatz ({AS});
   b) Erweitern (12) des Satzes ({S}) um neue Biegesequenzen ($BS_m$), die jeweils aus einer Biegesequenz ($BS_m$) des Auswahlsatzes ({AS}) ergänzt um zumindest eine weitere jeweils mögliche Biegungsvariante ($BV_{i,j}$) bestehen, über eine vorgegebene Zeitspanne ($\Delta t$) oder bis eine vorgegebene Anzahl neuer Biegesequenzen ($BS_m$) erreicht ist;
   c) Berechnen (13) eines Scores ($SC_m$) für jede Biegesequenz ($BS_m$) des Satzes ({S}) jeweils in Abhängigkeit von Bewertungen ($Eval_p$) der Biegungsvarianten ($BV_{i,j}$) in dieser Biegesequenz ($BS_m$) und der für die Berechnung dieser Biegesequenz ($BS_m$) verbrauchten Rechenzeit ($t_r$), wobei die verbrauchte Rechenzeit ein negatives Qualitätsmaß darstellt;
   d) Auswählen (14) der Biegesequenzen ($BS_m$) mit den N besten Scores ($SC_m$) unter allen Biegesequenzen ($BS_m$) des Satzes ({S}) und Speichern der ausgewählten Biegesequenzen ($BS_m$) als Auswahlsatz ({AS}) durch Überschreiben des alten Auswahlsatzes ({AS}) ;
   e) wenn eine vorgegebene Rechenzeit ($t_{ges}$) noch nicht erreicht ist, Wiederholen der Schritte b) bis d), andernfalls Biegen (18) des Blechrohlings (2) mit einer der Biegesequenzen ($BS_m$) des Auswahlsatzes ({AS}), in der alle Biegungen ($B_i$) vorhanden sind.

2. Verfahren nach Anspruch 1, **dadurch gekennzeichnet, dass** eine Biegung ($B_i$) durch einen Biegewinkel ($\alpha$), einen Biegeabstand (a) von einer Kante (7') des Blechrohlings (2) und optional einen Winkel ($\beta$) zu einer Kante (7') des Blechrohlings (2) definiert ist.

3. Verfahren nach Anspruch 1 oder 2, **dadurch gekennzeichnet, dass** eine Variante ($V_j$) einer Biegung ($B_i$) durch zumindest einen der Biegeparameter Biegerichtung (U/D), Blechrohling-Wenderichtung (FLIP), Blechrohling-Drehrichtung (ROT), Werkzeugwechsel (H/M) definiert ist.

4. Verfahren nach einem der Ansprüche 1 bis 3, **dadurch gekennzeichnet, dass** im Schritt b) das Erzeugen einer Biegesequenz ($BS_m$) das Anwenden eines Satzes von Regeln ({rule}) auf die jeweilige Biegesequenz ($BS_m$) des Auswahlsatzes ({AS}) und auf alle weiteren möglichen Biegungsvarianten ($BV_{i,j}$) umfasst, um zu ermitteln, welche dieser Biegesequenzen ($BS_m$) dem Satz hinzugefügt wird/werden.

5. Verfahren nach Anspruch 4, **dadurch gekennzeichnet, dass** jede Regel eine Bewertung ($Eval_p$) hinsichtlich eines im herzustellenden Werkstück (6) identifizierten Biegemusters, hinsichtlich der in der Biegesequenz ($BS_m$) enthaltenen Varianten ($V_j$) und/oder hinsichtlich auftretender Biegekollisionen liefert.

6. Verfahren nach einem der Ansprüche 1 bis 5, **dadurch gekennzeichnet, dass** die im Schritt c) ge-

nannten Bewertungen ($Eval_p$) hinsichtlich eines im herzustellenden Werkstück (6) identifizierten Biegemusters oder hinsichtlich der in der Biegesequenz ($BS_m$) enthaltenen Varianten ($V_j$) ermittelt werden.

7. Verfahren nach einem der Ansprüche 1 bis 5, **dadurch gekennzeichnet, dass** die genannte vorgegebene Zeitspanne ($\Delta t$) 0,1 bis 3 Sekunden, bevorzugt 0,2 bis 2 Sekunden beträgt.

8. Verfahren nach einem der Ansprüche 1 bis 5, **dadurch gekennzeichnet, dass** die genannte vorgegebene Rechenzeit ($t_{ges}$) 6 bis 20 Sekunden, bevorzugt 10 bis 15 Sekunden beträgt.

9. Computerprogrammprodukt zum Steuern einer programmierbaren Schwenkbiegemaschine (1), welches auf einem maschinenlesbaren Datenträger verkörpert und dafür ausgebildet ist, wenn die Schwenkbiegemaschine damit programmiert ist, das Verfahren nach einem der Ansprüche 1 bis 8 auszuführen.

10. Schwenkbiegemaschine mit einer Programmsteuerung, die dafür programmiert ist, das Verfahren nach einem der Ansprüche 1 bis 8 auszuführen.

**Claims**

1. Method for producing a work piece (6) with at least 2 bends ($B_i$) by bending a metal blank (2), wherein at least one of the bends ($B_i$) can be produced in two variants ($V_j$), comprising the following steps:

   a) providing (10) a set ({S}) of bending sequences ($BS_m$), each comprising a bending variant ($BV_{i,j}$), wherein the bending variants ($BV_{i,j}$) are constituted by the entirety of all bends ($B_i$) in all their variants ($V_j$), and storing (11) the set ({S}) as a selection set ({AS});
   b) extending (12) the set ({S}) by new bending sequences ($BS_m$) which each consist of a bending sequence ($BS_m$) of the selection set ({AS}) supplemented by at least one further possible bending variant ($BV_{i,j}$), over a predetermined time span ($\Delta t$) or until a predetermined number of new bending sequences ($BS_m$) has been reached;
   c) calculating (13) a score ($SC_m$) for each bending sequence ($BS_m$) of the set ({S}) each in independence of evaluations ($Eval_p$) of the bending variants ($BV_{i,j}$) in this bending sequence ($BS_m$) and the processing time ($t_r$) used for the calculation of this bending sequence ($BS_m$), wherein the used processing time is a negative measure of quality;
   d) selecting (14) the bending sequences ($BS_m$)

with the N best scores ($SC_m$) among all bending sequences ($BS_m$) of the set ({S}) and storing the selected bending sequences ($BS_m$) as selection set ({AS}) by overwriting the old selection set ({AS});
   e) unless a predetermined processing time ($t_{ges}$) has been reached, repeating the steps b) to d), else, bending (18) the metal blank (2) with one of the bending sequences ($BS_m$) of the selection set ({AS}) in which bending sequence all bends ($B_i$) are present.

2. Method according to claim 1, **characterized in that** a bend ($B_i$) is defined by a bending angle ($\alpha$), a bending distance (a) from an edge (7') of the metal blank (2), and, optionally, an angle ($\beta$) to an edge (7') of the metal blank (2).

3. Method according to claim 1 or 2, **characterized in that** a variant ($V_j$) of a bend ($B_i$) is defined by at least one of the bending parameters: bending direction (U/D), metal blank turning direction (FLIP), metal blank rotation direction (ROT), tool change (H/M).

4. Method according to any one of the claims 1 to 3, **characterized in that** in step b) generating a bending sequence ($BS_m$) comprises applying a set of rules ({rule}) to the respective bending sequence ($BS_m$) of the selection set ({AS}) and to all further possible bending variants ($BV_{i,j}$), in order to determine which of those bending sequences ($BS_m$) is/are added to the set.

5. Method according to claim 4, **characterized in that** each rule yields an evaluation ($Eval_p$) with respect to a bending pattern identified in the work piece (6) to be produced, with respect to the variants ($V_j$) contained in the bending sequence ($BS_n$), and/or with respect to occurring bending collisions.

6. Method according to any one of the claims 1 to 5, **characterized in that** the evaluations ($Eval_p$) cited in step c) are determined with respect to a bending pattern identified in the work piece (6) to be produced, or with respect to the variants ($V_j$) contained in the bending sequence ($BS_m$).

7. Method according to any one of the claims 1 to 5, **characterized in that** said predetermined time span ($\Delta t$) is 0.1 to 3 seconds, preferably 0.2 to 2 seconds.

8. Method according to any one of the claims 1 to 5, **characterized in that** said predetermined processing time ($t_{ges}$) is 6 to 20 seconds, preferably 10 to 15 seconds.

9. Computer program product for controlling a programmable swivel-bending machine (1), embodied on a machine-readable data carrier and configured to, when the swivel-bending machine is programmed therewith, execute the method according to any one of the claims 1 to 8.

10. Swivel-bending machine with a program control that is programmed to execute the method according to any one of the claims 1 to 8.

**Revendications**

1. Procédé de fabrication d'une pièce (6) dotée d'au moins deux coudes ($B_i$) par le pliage d'une ébauche en tôle (2), où au moins l'un des coudes ($B_i$) peut être réalisé en deux variantes ($V_j$), comprenant les étapes suivantes :

   a) mise au point (10) d'un ensemble ({S}) de séquences de pliage ($BS_m$) comprenant respectivement une variante de pliage ($BV_{i,j}$), où les variantes de pliage ($BV_{i,j}$) sont constituées de la totalité des coudes ($B_i$) dans toutes leurs variantes ($V_j$), et stockage (11) de l'ensemble ({S}]) en tant qu'ensemble de sélection ({AS}) ;
   b) extension (12) de l'ensemble ({S}) par des nouvelles séquences de pliage ($BS_m$), qui sont respectivement constituées d'une séquence de pliage ($BS_m$) de l'ensemble de sélection ({AS}) complétée respectivement d'au moins une autre variante de pliage ($BV_{i,j}$) possible, pendant un intervalle de temps ($\Delta t$) donné ou jusqu'à ce qu'un nombre prédéterminé de nouvelles séquences de pliage ($BS_m$) soit atteint ;
   c) calcul (13) d'un score ($SC_m$) pour chaque séquence de pliage ($BS_m$) de l'ensemble ({S}]), respectivement en fonction d'évaluations ($Eval_p$) des variantes de pliage ($BV_{i,j}$) dans cette séquence de pliage ($BS_m$) et du temps de calcul ($t_r$) utilisé pour le calcul de cette séquence de pliage ($BS_m$), où le temps de calcul utilisé représente une mesure négative de la qualité ;
   d) choix (14) des séquences de pliages ($BS_m$) avec les N meilleurs scores ($SC_m$) parmi toutes les séquences de pliage ($BS_m$) de l'ensemble ({S}) et stockage des séquences de pliage (BSm) choisies en tant qu'ensemble de sélection ({AS}) par la réécriture de l'ancien ensemble de sélection ({AS}) ;
   e) lorsqu'un temps de calcul prédéterminé ($t_{ges}$) n'est pas atteint, répétition des étapes b) à d), sinon, pliage (18) de l'ébauche en tôle (2) avec l'une des séquences de pliage ($BS_m$) de l'ensemble de sélection ({AS}) dans laquelle tous les coudes ($B_i$) sont présents.

2. Procédé selon la revendication 1, **caractérisé en ce qu'**un coude ($B_i$) est défini par un angle de pliage ($\alpha$), une distance de pliage (a) à partir d'un bord (7') de l'ébauche en tôle (2), et éventuellement par un angle ($\beta$) par rapport à un bord (7') de l'ébauche en tôle (2).

3. Procédé selon la revendication 1 ou 2, **caractérisé en ce qu'**une variante ($V_j$) d'un coude ($B_i$) est définie par au moins un des paramètres orientation du pliage (U/D), sens de giration (FLIP) de l'ébauche en tôle, sens de rotation (ROT) de l'ébauche en tôle, changement d'outil (H/M).

4. Procédé selon l'une des revendications 1 à 3, **caractérisé en ce que**, dans l'étape b), la création d'une séquence de pliage ($BS_m$) comprend l'application d'un ensemble de règles ({rule}) à la séquence de pliage ($BS_m$) respective de l'ensemble de sélection ({AS}) et à toutes les autres variantes de pliage ($BV_{i,j}$) possibles, afin de déterminer laquelle/lesquelles de ces séquences de pliage ($BS_m$) sera/seront ajoutée/s à l'ensemble.

5. Procédé selon la revendication 4, **caractérisé en ce que** chaque règle donne une évaluation ($EVAL_p$) concernant un motif de coude identifié dans la pièce (6) à fabriquer, concernant des variantes ($V_j$) contenues dans la séquence de pliage ($BS_m$) et/ou concernant des conflits dans les pliages pouvant se produire.

6. Procédé selon l'une des revendications 1 à 5, **caractérisé en ce que** dans l'étape c), des évaluations ($EVAL_p$) citées sont déterminées concernant un motif de pliage identifié dans la pièce (6) à fabriquer ou concernant des variantes ($V_j$) contenues dans la séquence de pliage ($BS_m$).

7. Procédé selon l'une des revendications 1 à 5, **caractérisé en ce que** l'intervalle de temps ($\Delta t$) prédéterminé cité est de 0,1 à 3 secondes, de préférence de 0,2 à 2 secondes.

8. Procédé selon l'une des revendications 1 à 5, **caractérisé en ce que** le temps de calcul ($t_{ges}$) prédéterminé cité est de 6 à 20 secondes, de préférence de 10 à 15 secondes.

9. Produit de programme informatique pour la commande d'une machine de pliage (1), représenté sur un support de données lisible par machine et est conçu, lorsque la machine de pliage est programmée avec celui-ci, pour exécuter le procédé selon l'une des revendications 1 à 8.

10. Machine de pliage dotée d'une commande programmée qui est programmée pour exécuter le procédé selon l'une des revendications 1 à 8.

**Fig. 1a**

**Fig. 1b**

**Fig. 2a**

**Fig. 2b**

**Fig. 2c**

| {B} | a | α | β |
|---|---|---|---|
| $B_1$ | 210 | 45° | 5° |
| $B_2$ | 230 | 90° | 0° |
| $B_i$ | | | |

**Fig. 3**

| $B_i$ | U/D | FLIP | ROT | H/M |
|---|---|---|---|---|
| $V_1$ | 1 | 0 | 0 | 1 |
| $V_2$ | 0 | 1 | 0 | 1 |
| $V_j$ | | | | |

**Fig. 4**

(a)          (b)

**Fig. 6**

*Fig. 5*

$B_m$ ——————

$B_{m+n}$ ·················

{AS} ▬▬▬▬▬

{rule}
rule$_1$
rule$_2$
⋮
rule$_k$

rule$_1$

BS$_m$ →
{BV} →
| PatEval | → Eval$_1$

rule$_2$

BS$_m$ →
{BV} →
| VarEval | → Eval$_2$

rule$_3$

BS$_m$ →
{BV} →
| ColEval | → Eval$_3$

*Fig. 7*

*Fig. 8*

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- DE 69535687 T2